# EUROPEAN PATENT APPLICATION

(11) **EP 2 722 892 A1**
(43) Date of publication of application: **23.04.2014**
(21) Application number: 12800187.2
(22) Date of filing: 29.05.2012
(51) Int. Cl.: H01L 29/78, H01L 21/28, H01L 21/336, H01L 29/12, H01L 29/423, H01L 29/49

(54) **SILICON CARBIDE SEMICONDUCTOR DEVICE AND METHOD FOR MANUFACTURING SAME**

(30) Priority: 15.06.2011 JP 2011132784
(71) Applicant: Sumitomo Electric Industries, Ltd., Osaka-shi, Osaka 541-0041 (JP)
(72) Inventor: HONAGA, Misako, Osaka-shi Osaka 554-0024 (JP); MASUDA, Takeyoshi, Osaka-shi Osaka 554-0024 (JP)
(74) Representative: Grünecker, Kinkeldey, Stockmair & Schwanhäusser
(86) International application number: PCT/JP2012/063722
(87) International publication number: WO 2012/172965

(57) **Abstract**

A gate electrode (50) includes a polysilicon film (51) in contact with a gate insulating film (41), a barrier film (52) provided on the polysilicon film (51), a metal film (53) provided on the barrier film (52) and made of refractory metal. An interlayer insulating film (42) is arranged so as to cover the gate insulating film (41) and the gate electrode (50) provided on the gate insulating film (41). The interlayer insulating film (42) has a substrate contact hole (SH) partially exposing a silicon carbide substrate (30) in a region in contact with the gate insulating film (41). A interconnection (71) is electrically connected to the silicon carbide substrate (30) through the substrate contact hole (SH) and is electrically insulated from the gate electrode (50) by the interlayer insulating film (42).

## Description

### TECHNICAL FIELD

The present invention relates to a silicon carbide semiconductor device and a method for manufacturing the same, and more particularly to a silicon carbide semiconductor device having a gate electrode, and a method for manufacturing the same.

### BACKGROUND ART

Japanese Patent Laying-Open No. 2010-171417 (PTL 1) discloses a MOSFET (Metal Oxide Semiconductor Field Effect Transistor) including a silicon carbide substrate, a gate pad, and a gate electrode. The gate electrode is made of polysilicon.

### CITATION LIST

### PATENT LITERATURE

PTL 1: Japanese Patent Laying-Open No. 2010-171417

### SUMMARY OF INVENTION

### TECHNICAL PROBLEM

According to the art disclosed in the aforementioned publication, it was difficult to obtain a sufficiently lowered electric resistance in a gate electrode extending from a gate pad on a silicon carbide substrate. As a result, especially in a case where a silicon carbide semiconductor device includes a plurality of cells, each having a semiconductor element structure, and a gate pad, a resistance value between a gate pad and a gate structure included in a cell located close to the gate pad and a resistance value between the gate pad and a gate structure included in a cell located far away from the gate pad have greatly varied.

The present invention was made to solve such a problem, and its object is to provide a silicon carbide semiconductor device capable of suppressing electric resistance of a gate electrode, and to provide a method for manufacturing the same.

### SOLUTION TO PROBLEM

The silicon carbide semiconductor device according to the present invention includes a silicon carbide substrate, a gate insulating film, a gate electrode, an interlayer insulating film, and an interconnection. The gate insulating film is provided on the silicon carbide substrate. The gate electrode is provided on the gate insulating film. The gate electrode includes a polysilicon film in contact with the gate insulating film, a barrier film provided on the polysilicon film, and a metal film made of refractory metal and provided on the barrier film. The interlayer insulating film is arranged so as to cover the gate insulating film and the gate electrode provided on the gate insulating film. The interlayer insulating film has a substrate contact hole which partially exposes the silicon carbide substrate at a region in contact with the gate insulating film. The interconnection is electrically connected to the silicon carbide substrate through the substrate contact hole, and is electrically insulated from the gate electrode by the interlayer insulating film.

According to the silicon carbide semiconductor device of the present invention, the gate electrode includes the refractory metal film having lower resistivity than the polysilicon film. Thus, the electric resistance of the gate electrode can be suppressed further as compared to a case where the gate electrode is formed only by a polysilicon film.

Preferably, the interlayer insulating film has a gate contact hole which partially exposes the gate electrode. The silicon carbide semiconductor device has a gate pad which is electrically connected to the gate electrode through the gate contact hole. Thus, a current path extending from the gate pad can be formed by the gate electrode having low electric resistance. More preferably, the interconnection and the gate pad are made of the same material. Thus, the silicon carbide semiconductor device can be manufactured more easily as compared to a case where the material of the interconnection and the material of the gate pad are different.

Preferably, the refractory metal has a melting point which is over 1000°C. Thus, heat treatment over 1000°C can be performed after a metal film made of the refractory metal is formed.

The silicon carbide substrate may be provided with a trench, and at least a part of the gate electrode may be arranged in the trench. Thus, electric resistance of the gate electrode can be suppressed further.

A method for manufacturing a silicon carbide semiconductor device of the present invention includes the following steps.

A gate insulating film is formed on a silicon carbide substrate. A gate electrode is formed on the gate insulating film. The step of forming a gate electrode includes the steps of forming a polysilicon film in contact with the gate insulating film, forming a barrier film on the polysilicon film, and forming a metal film made of refractory metal on the barrier film. An interlayer insulating film is formed, arranged to cover the gate insulating film and the gate electrode provided on the gate insulating film, and having a substrate contact hole partially exposing the silicon carbide substrate at a region in contact with the gate insulating film. An interconnection is formed, electrically connected to the silicon carbide substrate through the substrate contact hole, and electrically insulated from the gate electrode by the interlayer insulating film.

According to the method for manufacturing a silicon carbide semiconductor device of the present invention, the gate electrode includes a refractory metal film having lower resistivity than the polysilicon film. Therefore, the electric resistance of the gate electrode can be suppressed further as compared to the case where the gate electrode is formed only by the polysilicon film.

Preferably, in the method for manufacturing a silicon carbide semiconductor device, heat treatment is applied to the silicon carbide substrate to render the electrical connection between the interconnection and the silicon carbide substrate more ohmic. Thus, the electrical connection between the interconnection and the silicon carbide substrate can be rendered more ohmic. More preferably, the step of applying heat treatment to the silicon carbide substrate includes the step of heating the silicon carbide substrate to a temperature higher than 1000°C. Thus, the electrical connection between the interconnection and the silicon carbide substrate can be rendered more ohmic.

Preferably, the step of forming the interconnection includes the step of forming a conductor film in contact with each of the gate electrode and the silicon carbide substrate, and the step of patterning the conductor film. The step of patterning forms the interconnection and the gate pad provided on a part of the gate electrode. Thus, the silicon carbide semiconductor device can be manufactured more easily as compared to a case where the interconnection and the gate pad are formed separately.

A trench may be formed on the silicon carbide substrate, and at least a part of the gate electrode may be arranged in the trench. Thus, electric resistance of the gate electrode can be suppressed further.

### ADVANTAGEOUS EFFECTS OF INVENTION

As being clear from the description above, according to the silicon carbide semiconductor device of the present invention, electric resistance can be suppressed.

### BRIEF DESCRIPTION OF DRAWINGS

Fig. 1 is a plan view schematically showing a structure of a silicon carbide semiconductor device in a first embodiment.
Fig. 2 is a schematic cross-sectional view taken along line II-II of Fig. 1.
Fig. 3 is a cross-sectional view schematically showing a first step in a method for manufacturing the silicon carbide semiconductor device of Fig. 1, corresponding to the view of Fig. 2.
Fig. 4 is a cross-sectional view schematically showing a second step in the method for manufacturing the silicon carbide semiconductor device of Fig. 1, corresponding to the view of Fig. 2.
Fig. 5 is a cross-sectional view schematically showing a third step in the method for manufacturing the silicon carbide semiconductor device of Fig. 1, corresponding to the view of Fig. 2.
Fig. 6 is a cross-sectional view schematically showing a fourth step in the method for manufacturing the silicon carbide semiconductor device of Fig. 1, corresponding to the view of Fig. 2.
Fig. 7 is a cross-sectional view schematically showing a fifth step in the method for manufacturing the silicon carbide semiconductor device of Fig. 1, corresponding to the view of Fig. 2.
Fig. 8 is a cross-sectional view schematically showing a sixth step in the method for manufacturing the silicon carbide semiconductor device of Fig. 1, corresponding to the view of Fig. 2.
Fig. 9 is a cross-sectional view schematically showing a seventh step in the method for manufacturing the silicon carbide semiconductor device of Fig. 1, corresponding to the view of Fig. 2.
Fig. 10 is a cross-sectional view schematically showing an eighth step in the method for manufacturing the silicon carbide semiconductor device of Fig. 1, corresponding to the view of Fig. 2.
Fig. 11 is a cross-sectional view schematically showing a ninth step in the method for manufacturing the silicon carbide semiconductor device of Fig. 1, corresponding to the view of Fig. 2.
Fig. 12 is a cross-sectional view schematically showing a structure of a silicon carbide semiconductor device in a second embodiment, corresponding to the view of Fig. 2.
Fig. 13 is a cross-sectional view schematically showing a first step in a method for manufacturing the silicon carbide semiconductor device of Fig. 12, corresponding to the view of Fig. 12.
Fig. 14 is a cross-sectional view schematically showing a second step in the method for manufacturing the silicon carbide semiconductor device of Fig. 12 in the view corresponding to the view of Fig. 12.
Fig. 15 is a cross-sectional view schematically showing a modified example of the structure shown in Fig. 12.

### DESCRIPTION OF EMBODIMENTS

Hereinafter, embodiments of the present invention will be described with reference to the drawings. In the drawings below, the same or corresponding elements have the same reference characters allotted, and description thereof will not be repeated. Also, regarding the crystallographic description in the specification, a group orientation including equivalent individual orientations is indicated by <>, an individual plane is indicated by (), and a group plane including equivalent individual planes is indicated by {}. Moreover, to indicate that an index is negative, a negative sign is allotted before numerals, instead of adding "-" (bar) above numerals.

### (First Embodiment)

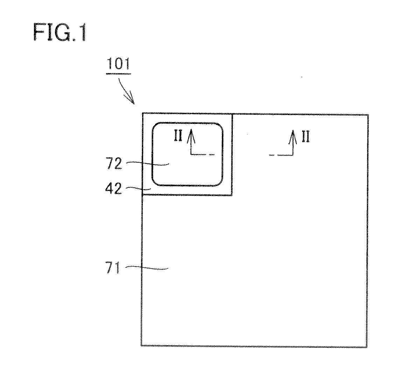

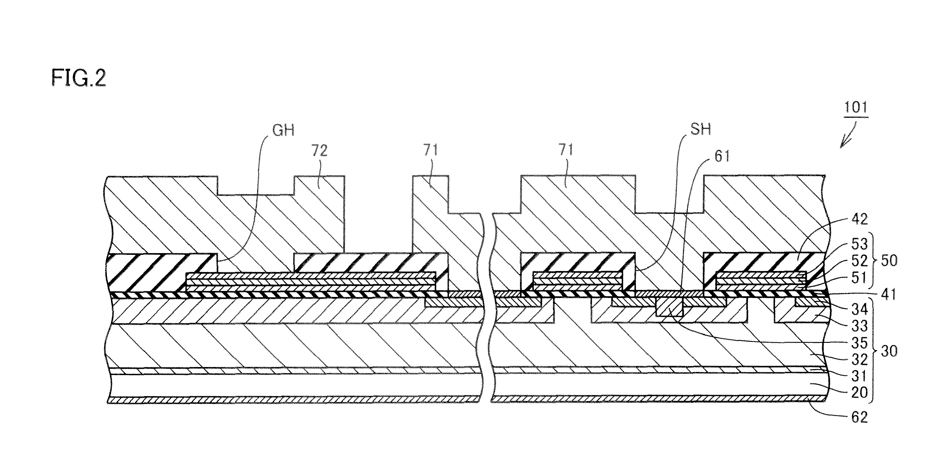

As shown in Figs. 1 and 2, a silicon carbide semiconductor device of the present embodiment is a MOSFET 101, and more specifically a DiMOSFET (Double implanted MOSFET). MOSFET 101 includes a silicon carbide substrate 30, a gate insulating film 41, a gate electrode 50, an interlayer insulating film 42, a source interconnection 71 (interconnection), an ohmic electrode 61, and a drain electrode 62.

Silicon carbide substrate 30 has a single-crystal wafer 20 having n-type conductivity (first conductivity type), a buffer layer 31 made of silicon carbide having n-type conductivity, a drift layer 32 made of silicon carbide having n-type conductivity, a pair of p-type body regions 33 having p-type conductivity (second conductivity type), an n⁺ region 34 having n-type conductivity, and a p⁺ region 35 having p-type conductivity.

Single-crystal wafer 20 is of an n-type. Buffer layer 31 is epitaxially formed on a main surface of single-crystal wafer 20, and is doped with conduction impurities to be of an n-type. Drift layer 32 is epitaxially formed on buffer layer 31, and is doped with conduction impurities to be of an n-type. The impurity concentration per volume of drift layer 32 is lower than the impurity concentration per volume of buffer layer 31. For example, the conduction impurity is nitrogen (N). The pair of p-type body regions 33 are separated from one another on a main surface (upper surface in Fig. 2) of silicon carbide substrate 30. P-type body regions 33 are doped with conduction impurities to be of a p-type. For example, the conduction impurity is aluminum (Al) or boron (B). Each n⁺ region 34 is provided on the main surface of silicon carbide substrate 30, and is separated from drift layer 32 by p-type body regions 33. The impurity concentration of n⁺ region 34 is higher than the impurity concentration of drift layer 32. P⁺ region 35 extends from the main surface of silicon carbide substrate 30 and reaches p-type body regions 33, and is adjacent to n⁺ region 34 on the main surface of silicon carbide substrate 30. The impurity concentration of p⁺ region 35 is higher than the impurity concentration of p-type body regions 33.

Gate insulating film 41 is provided directly on the main surface of silicon carbide substrate 30, and extends from an upper surface of one n⁺ region 34 to an upper surface of another n⁺ region 34. The gate insulating film is preferably an oxide film and is made of, for example, silicon dioxide (SiO₂).

Gate electrode 50 is provided directly on gate insulating film 41, and extends from a location above one n⁺ region 34 to a location above another n⁺ region 34. Gate electrode 50 includes a polysilicon film 51 in contact with gate insulating film 41, a barrier film 52 provided on polysilicon film 51, and a metal film 53 provided on barrier film 52.

Polysilicon film 51 is made of polysilicon to which conduction impurities are added. The thickness of polysilicon film 51 is, for example, about 400nm.

Barrier film 52 is made of a material which is less susceptible to silicidation as compared to metal film 53, such as titanium (Ti), titanium nitride (TiN), titanium tungsten (TiW), tungsten nitride (WN), or tantalum nitride (TaW). The thickness of barrier film 52 is, for example, about 50nm.

Metal film 53 is made of refractory metal. The refractory metal preferably has a melting point higher than 1000°C. The resistivity of metal film 53 is lower than the resistivity of polysilicon film 51. Specifically, the refractory metal is based on any one of Au, Cu, Si, Ni, Mo, Ta, and W, or made of an alloy including at least two of these elements. A thickness of metal film 53 is, for example, about 50-400nm.

Interlayer insulating film 42 is provided on silicon carbide substrate 30 in the region where gate insulating film 41 and gate electrode 50 are provided. Also, interlayer insulating film 42 is provided with a source contact hole SH (substrate contact hole), which exposes a part of each n⁺ region 34 and p⁺ region 35, and a gate contact hole GH, which locally exposes gate electrode 50. Interlayer insulating film 42 is made of, for example, silicon dioxide (SiO₂).

Source interconnection 71 is electrically connected to silicon carbide substrate 30 through source contact hole SH. Also, source interconnection 71 is electrically insulated from gate electrode 50 by interlayer insulating film 42. Source interconnection 71 is made of, for example, aluminum (Al). In the present embodiment, source interconnection 71 serves as a pad. In other words, source interconnection 71 is configured to allow wire bonding thereon.

Ohmic electrode 61 is provided between source interconnection 71 and silicon carbide substrate 30. Ohmic electrode 61 is made of a material which can be in ohmic contact with n⁺ region 34, and specifically is made of silicide, e.g. NiₓSi_{y} (nickel silicide).

Gate pad 72 is provided on a part of gate electrode 50. Gate pad 72 is electrically connected to gate electrode 50 through gate contact hole GH. Gate pad 72 is made of, for example, aluminum (Al).

Drain electrode 62 is in contact with and on single-crystal wafer 20 included in silicon carbide substrate 30. Drain electrode 62 is made of a material which can be in ohmic contact with silicon carbide substrate 30, and specifically is made of silicide, e.g. NiₓSi_{y} (nickel silicide).

Next, a method for manufacturing MOSFET 101 will be described.

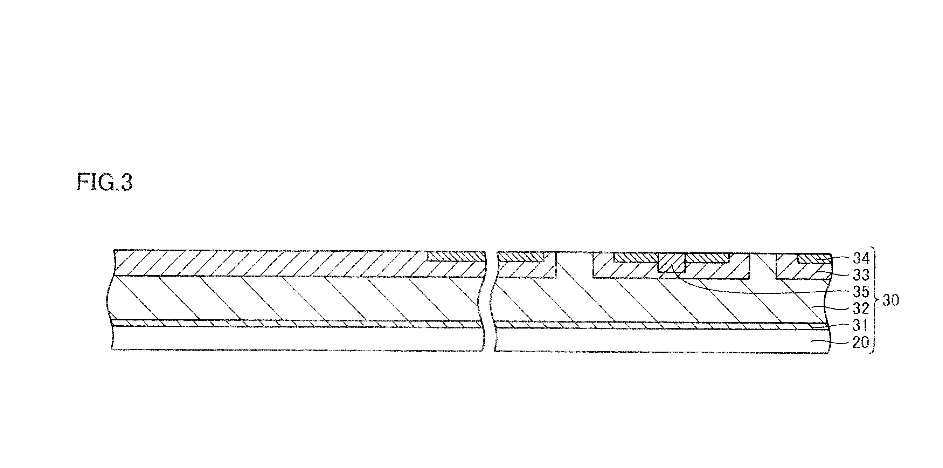

As shown in Fig. 3, silicon carbide substrate 30 is prepared. Specifically, the following steps are performed.

Firstly, single-crystal wafer 20 of silicon carbide is prepared. Next, buffer layer 31 and drift layer 32, both made of silicon carbide, are epitaxially grown in sequence on the main surface of single-crystal wafer 20. For example, a CVD (Chemical Vapor Deposition) method can be used for the epitaxial growth.

Next, ion implantation is carried out. Specifically, ion implantation for forming p-type body regions 33 is carried out. Specifically, for example, Al (aluminum) ions are implanted to drift layer 32, so that p-type body regions 33 are formed. Next, ion implantation for forming n⁺ region 34 is carried out. Specifically, for example, P (phosphorus) ion is implanted to p-type body region 33, so that n⁺ region 34 is formed in p-type body region 33. Further, ion implantation for forming p⁺ region 35 is carried out. Specifically, for example, Al ions are implanted to p-type body region 33, so that p⁺ region 35 is formed in p-type body region 33. The ion implantation can be carried out, for example, by forming a mask layer on main surface of drift layer 32. The mask layer is made of silicon dioxide (SiO₂) and has an opening in a desired region where the ion implantation should be carried out.

Next, activation heat treatment is performed. For example, heat treatment is performed which includes heating to 1700°C in an atmosphere of an inert gas such as argon and holding for 30 minutes. Thus, the implanted impurities are activated.

Silicon carbide substrate 30 is prepared by the procedures described above.

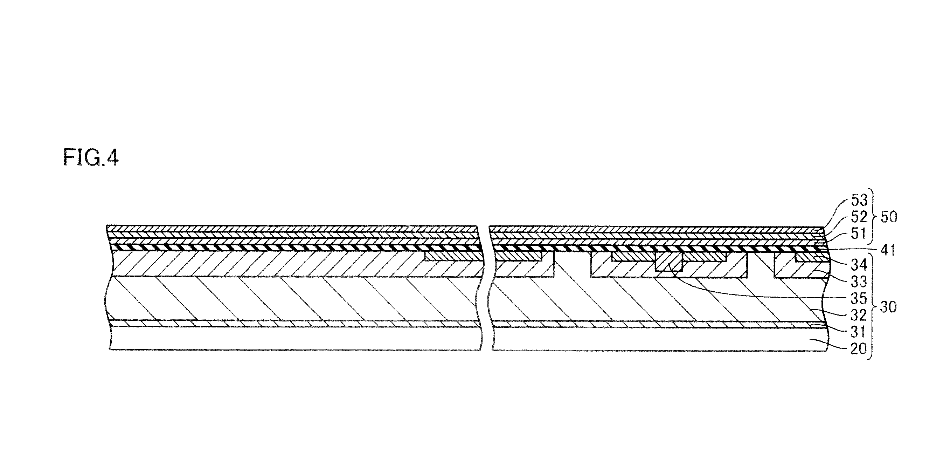

As shown in Fig. 4, gate insulating film 41 is formed on silicon carbide substrate 30. Specifically, an oxide film serving as gate insulating film 41 is formed by performing heat treatment which includes heating to 1300°C in an oxygen atmosphere and holding for 60 minutes. Thereafter, heat treatment may be performed using nitric monoxide (NO) gas as an atmosphere gas. The conditions for the heat treatment include heating at a temperature equal to or greater than 1100°C and equal to or less than 1300°C for about 1 hour. Such heat treatment allows nitrogen atoms to be introduced into an interface region between gate insulating film 41 and drift layer 32. Thus, formation of an interface state at the interface region between gate insulating film 41 and drift layer 32 is suppressed, so that channel mobility of the eventually obtained MOSFET 101 can be improved. Instead of using an NO gas, other gas may be used which is capable of introducing nitrogen atoms into the interface region between gate insulating film 41 and drift layer 32. Further, after the heat treatment for introducing nitrogen atoms, heat treatment at a temperature higher than the heat treatment described above can be performed using an argon (Ar) atmosphere in order to further suppress the forming of the interface state.

Next, gate electrode 50 is formed on gate insulating film 41. Specifically, polysilicon film 51 in contact with gate insulating film 41 is firstly formed. Polysilicon film 51 may be formed, for example, using the CVD method. Next, barrier film 52 is formed on polysilicon film 51. Next, metal film 53 is formed on barrier film 52. Barrier film 52 and metal film 53 may be formed, for example, using a deposition method.

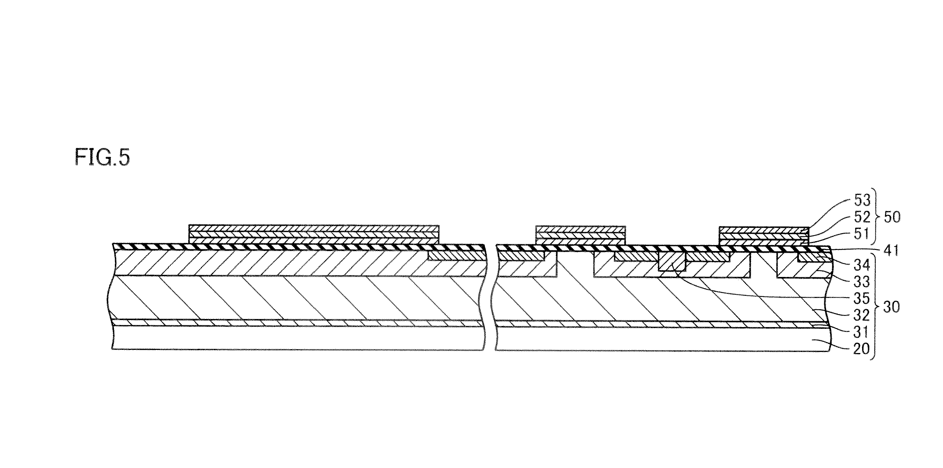

As shown in Fig. 5, gate electrode 50 is patterned. The patterning can be performed, for example, using photolithography and etching.

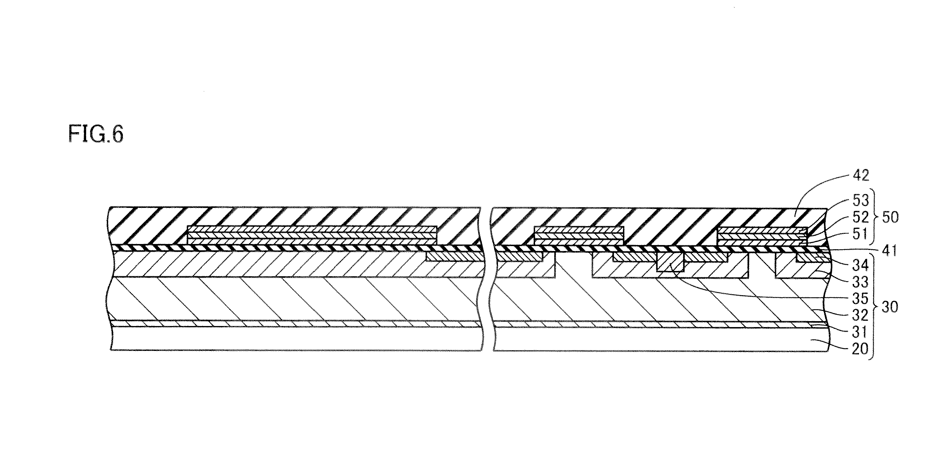

As shown in Fig. 6, interlayer insulating film 42 is formed on silicon carbide substrate 30 having gate insulating film 41 and gate electrode 50 formed thereon. Interlayer insulating film 42 may be formed, for example, by the CVD method.

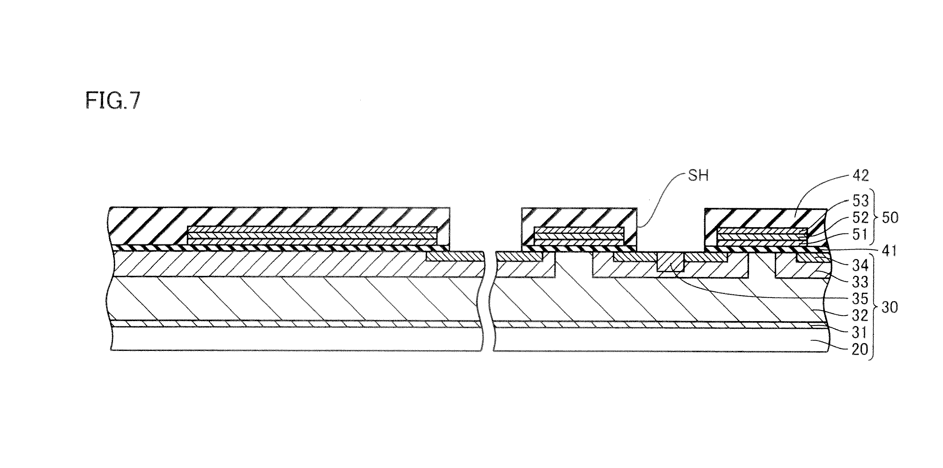

As shown in Fig. 7, source contact hole SH which partially exposes silicon carbide substrate 30 is formed on interlayer insulating film 42 and gate insulating film 41. This step can be performed, for example, using photolithography and etching.

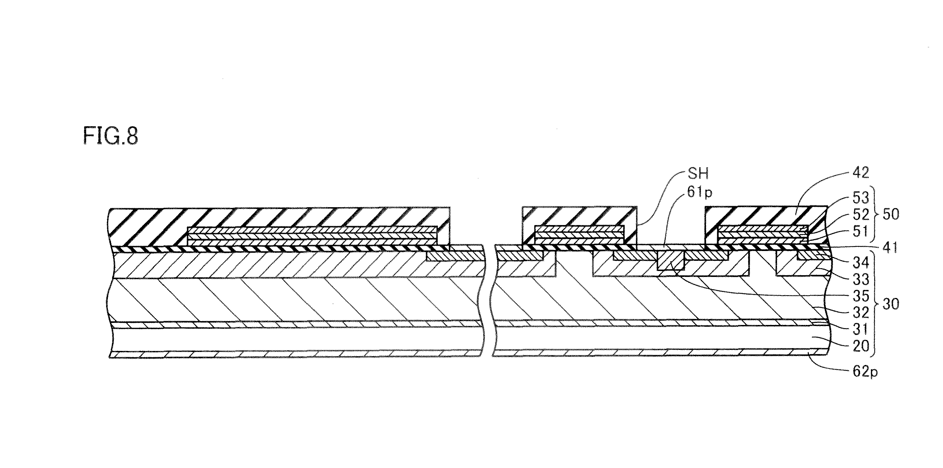

As shown in Fig. 8, a film 61p is formed within source contact hole SH on silicon carbide substrate 30. Film 61p is made of a material which enables film 61p to be in ohmic contact with silicon carbide substrate 30 by heating, and specifically is made of a material e.g. nickel (Ni) which can be silicided. Further, in the present embodiment, on the back side of single-crystal wafer 20 included in silicon carbide substrate 30, a film 62p which is made of a material substantially the same as the material of film 61p is formed. This step may be performed, for example, using the deposition method.

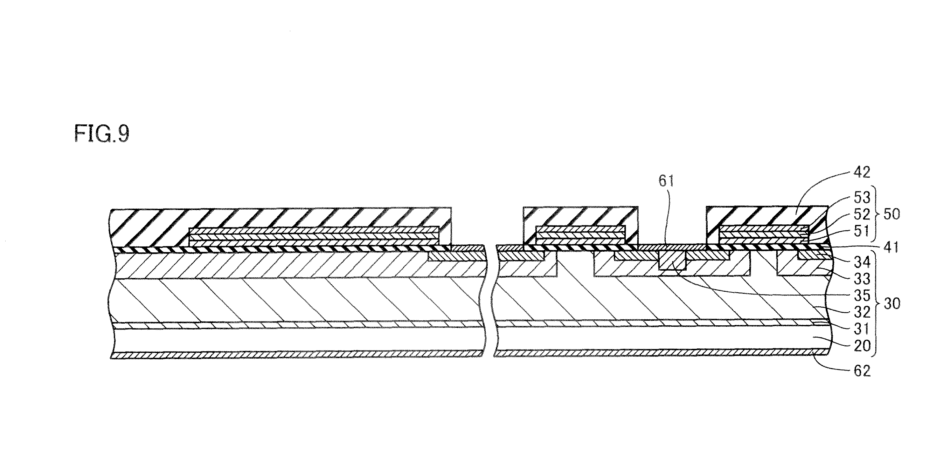

As shown in Fig. 9, heat treatment is applied to silicon carbide substrate 30. The temperature of the heat treatment is set at a level sufficient to facilitate an ohmic contact between silicon carbide substrate 30 and film 61 p (Fig. 8), preferably above 1000°C. Film 61p formed on the silicon carbide substrate is heated by this heat treatment, so that an ohmic electrode 61 is formed from film 61p. Further, drain electrode 62 is formed by heating film 62p (Fig. 8) formed on the back side of single-crystal wafer 20 included in silicon carbide substrate 30.

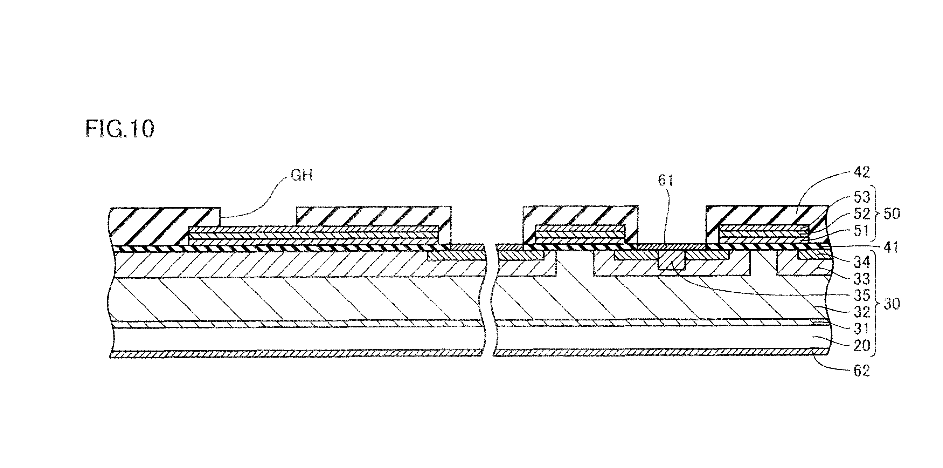

As shown in Fig. 10, gate contact hole GH is formed on interlayer insulating film 42. Thus, a part of gate electrode 50 is exposed. This step can be performed, for example, using photolithography and etching.

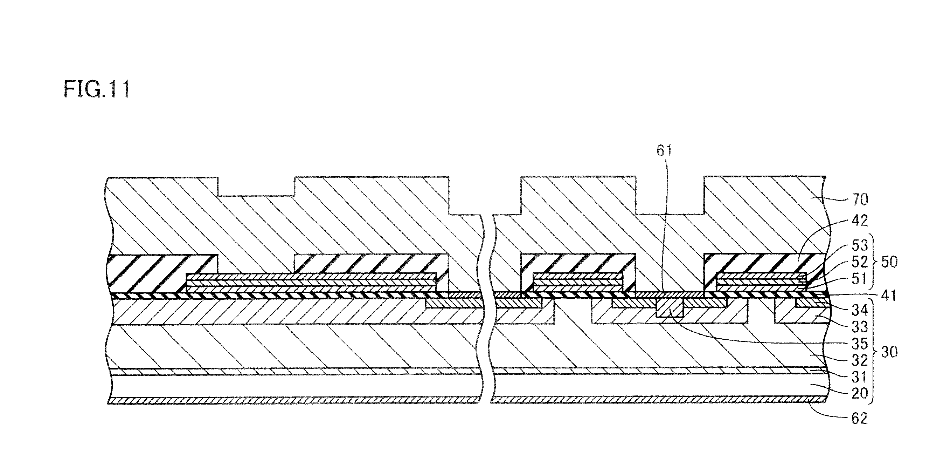

As shown in Fig. 11, film 70 made of metal is formed. This metal is, for example, aluminum. The term "metal" used in the specification includes not only a single substance but also an alloy. Further, film 70 is not limited to a single-layered film, and may be a multi-layered film. This multi-layered film may be formed by forming a barrier film and forming an aluminum film on the barrier film. The material of film 70 is the same as the material for source interconnection 71 and gate pad 72.

Next, as shown in Fig. 2, film 70 is patterned, so that source interconnection 71 and gate pad 72 are formed separately. Thus, MOSFET 101 can be obtained.

According to the present embodiment, gate electrode 50 includes metal film 53 having lower resistivity than polysilicon film 51. Therefore, the electric resistance can be suppressed further as compared to the case where gate electrode 50 is formed only by polysilicon film 51. Thus, a current path extending from gate pad 72 can be formed by gate electrode 50 having low electric resistance.

In the case where the gate electrode is formed only by polysilicon without using metal film 53, an attempt to obtain a gate electrode having resistance as small as the embodiment of the present embodiment would lead to an excessively thick gate electrode because the resistivity of the polysilicon is higher than the resistivity of the metal film. If the thickness of the gate electrode having a pattern is excessively large, large protrusions and recesses corresponding to this pattern are formed on silicon carbide substrate 30. On the other hand, according to the present embodiment, the thickness of the gate electrode can be made smaller by using metal film 53 having a low resistivity. Therefore, the protrusions and recesses formed on silicon carbide substrate 30 can be suppressed.

Further, the heat treatment is applied to silicon carbide substrate 30, so that ohmic electrode 61 is formed between source interconnection 71 and silicon carbide substrate 30. Thus, the electrical connection between source interconnection 71 and silicon carbide substrate 30 can be made more ohmic. Preferably, the temperature of the heat treatment is over 1000°C. Thus, the connection between source interconnection 71 and silicon carbide substrate 30 can be rendered more ohmic.

Preferably, the refractory metal as the material for metal film 53 has a melting point exceeding 1000°C. Thus, after metal film 53 is formed, heat treatment higher than 1000°C can be performed.

Further, in the present embodiment, source interconnection 71 and gate pad 72 are made of the same material. Thus, as compared to the case where the material of source interconnection 71 and the material of gate pad 72 are different, MOSFET 101 can be manufactured more easily. Specifically, source interconnection 71 and gate pad 72 can be formed concurrently by patterning film 70.

It is preferable that the main surface of single-crystal wafer 20 on a side facing buffer layer 31 has an off angle equal to or greater than 50° and equal to or less than 65° with respect to the {0001} plane. Thus, the channel mobility can be improved. Further, it is preferable that an angle between the off orientation of the off angle and the <01-10> direction is equal to or less than 5°. Thus, the epitaxial growth on the single-crystal wafer 20 can be facilitated.

Further, it is preferable that an off angle of the main surface with respect to a {03-38} plane in the <01-10> direction is equal to or greater than -3° and equal to or less than 5°, and more preferably the main surface is substantially the {03-38} plane. Thus, the channel mobility can be improved further.

The angle between the off orientation of the main surface and the <-2110> direction may be equal to or less than 5°. Thus, the epitaxial growth on single-crystal wafer 20 can be facilitated.

Further, it is preferable that the main surface is the face on the side of a carbon surface of silicon carbide constituting single-crystal wafer 20. The surface on the side of the carbon surface is a surface which has a negative value in m when expressed by the plane orientation (hklm). It is more preferable that the plane is the (0-33-8) plane. Thus, the channel mobility can be further improved.

### (Second Embodiment)

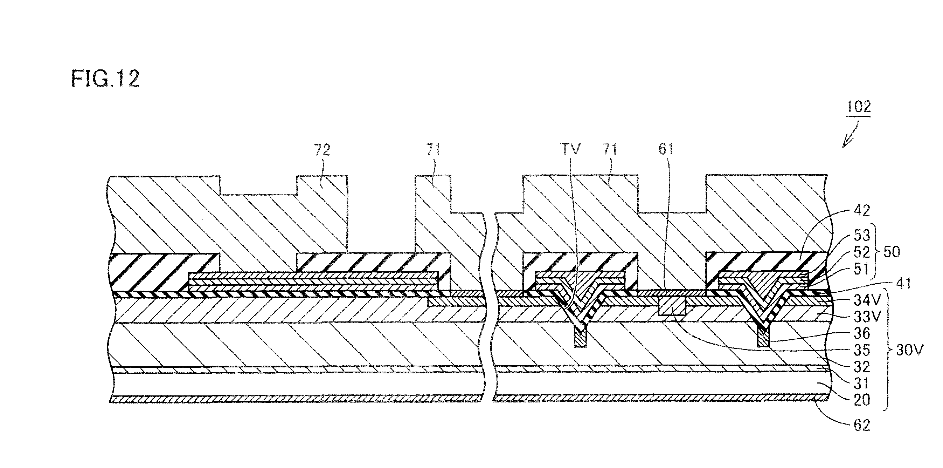

As shown in Fig. 12, the silicon carbide semiconductor device of the present embodiment is a MOSFET 102, and more specifically is a VMOSFET (V-groove MOSFET). MOSFET 102 has a silicon carbide substrate 30V. Silicon carbide substrate 30V has a trench TV, and also includes a p-type body region 33V, an n-type n⁺ region 34V, and a relaxation region 36. Trench TV has a V-shape passing through n⁺ region 34V and p-type body region 33V to reach drift layer 32. A preferable plane orientation of the side wall of trench TV is the same as the preferable plane orientation of the main surface of single-crystal wafer 20 (Fig. 2). Relaxation region 36 faces a bottom portion of trench TV through gate insulating film 41. Relaxation region 36 has a higher impurity concentration than the impurity concentration of drift layer 32 and serves to relax an electric field at the bottom portion of trench TV.

Next, a method for manufacturing MOSFET 102 will be described below.

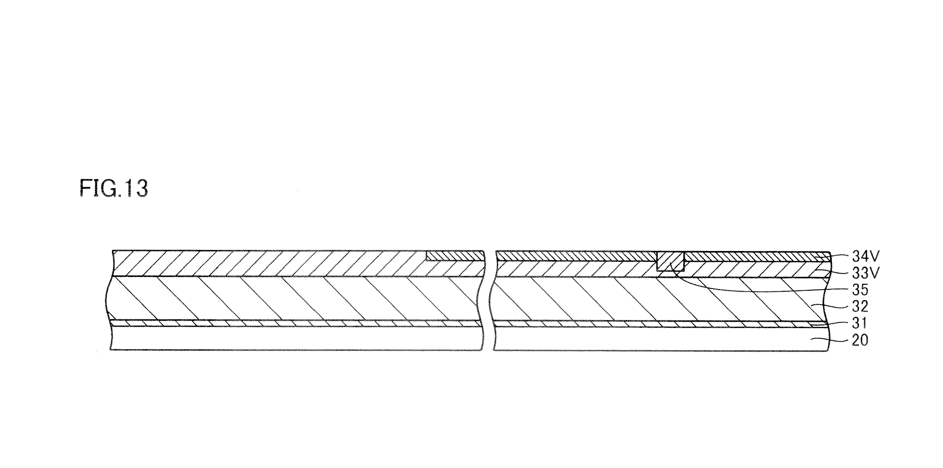

As shown in Fig. 13, similarly to the first embodiment, buffer layer 31 and drift layer 32 are epitaxially grown in sequence on the main surface of single-crystal wafer 20. Then, p-type body region 33V and n⁺ region 34V are formed. P-type body region 33V may be formed by the ion implantation or by the epitaxial growth. N⁺ region 34V may be formed by the ion implantation.

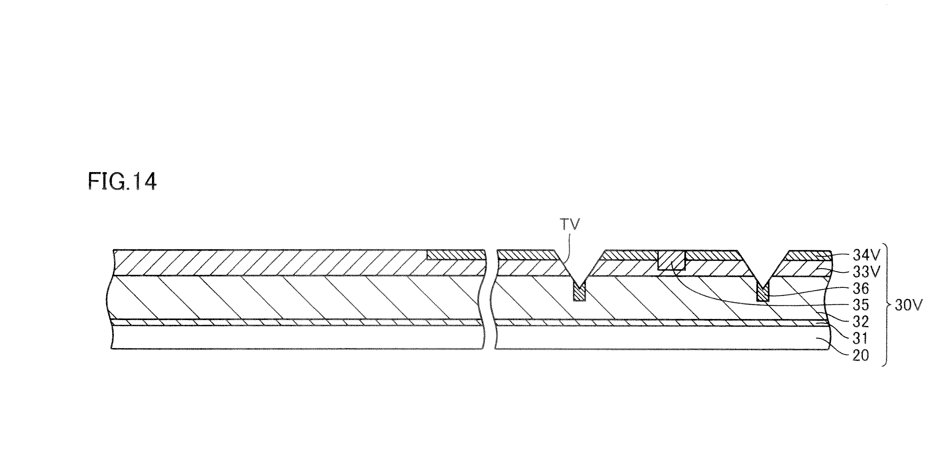

As shown in Fig. 14, trench TV is formed. The trench can be formed, for example, using photolithography and etching. Then, the ion implantation is carried out to form relaxation region 36 at the bottom portion of trench TV. Then, heat treatment for activating impurity is performed. Then, steps substantially the same as those of Fig. 4 to Fig. 11 of the first embodiment are performed to obtain MOSFET 102 (Fig. 12).

The configuration other than those described above is substantially the same as the configuration of the first embodiment described above. Therefore, the same or corresponding elements have the same reference characters allotted, and description thereof will not be repeated.

According to the present embodiment, gate electrode 50 has a portion arranged in trench TV. Presence of this portion allows the cross-sectional area (area in Fig. 12) of gate electrode 50 to be increased without excessively increasing the protrusions and recesses on silicon carbide substrate 30, so that the electric resistance of the gate electrode 50 can be further suppressed.

### (Third Embodiment)

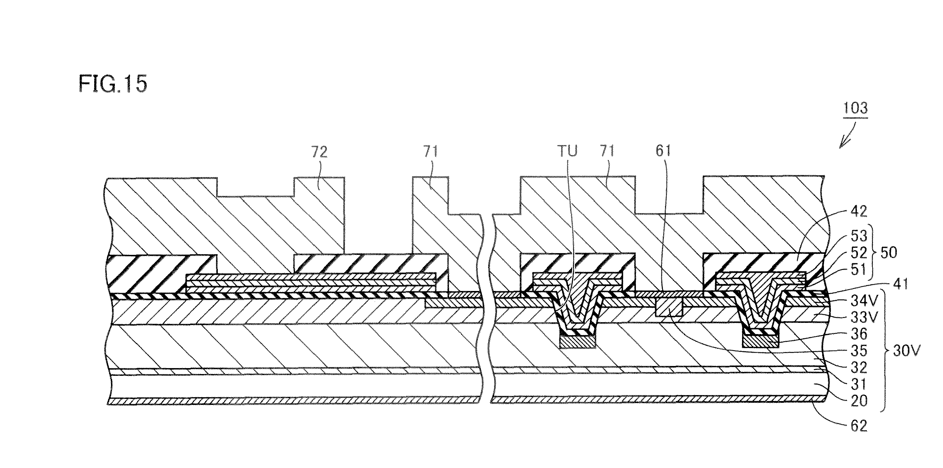

As shown in Fig. 15, the silicon carbide semiconductor device of the present embodiment is a MOSFET 103, and it has a trench TU in place of trench TV of MOSFET 102 (Fig. 12). Being different from trench TV, trench TU has a substantially flat bottom portion.

The configuration other than those described above is substantially the same as the second embodiment, thus the same or corresponding elements have the same reference characters allotted, and description thereof will not be repeated.

In each of MOSFETs 101-103, the n-type and the p-type can be switched. Further, the silicon carbide semiconductor device may be a MISFET (Metal Insulator Semiconductor Field Effect Transistor) other than MOSFET. In other words, gate insulating film 41 is not limited to oxide. Further, the silicon carbide semiconductor device is not limited to the MISFET, and it may be a device of other kind having a gate electrode. For example, the device may be an IGBT (Insulated Gate Bipolar Transistor). Further, the interconnection and the gate pad do not necessarily have to be made of the same material.

It should be understood that the embodiments and examples disclosed herein are illustrative and non-restrictive in every respect. The scope of the present invention is defined by the terms of claims, rather than the description of the embodiments set forth above, and is intended to include any modifications within the scope and meaning equivalent to the terms of the claims.

### REFERENCE SIGNS LIST

20 single-crystal wafer; 30, 30V silicon carbide substrate; 31 buffer layer; 32 drift layer; 33, 33V p-type body region; 34, 34V n⁺ region; 35 p⁺ region; 36 relaxation region; 41 gate insulating film; 42 interlayer insulating film; 50 gate electrode; 51 polysilicon film; 52 barrier film; 53 metal film; 61 ohmic electrode; 62 drain electrode; 71 source interconnection; 72 gate pad; 101-103 MOSFET (semiconductor device); GH gate contact hole; SH source contact hole (substrate contact hole); TU, TV trench.

## Claims

1. A silicon carbide semiconductor device (101-103), comprising:
a silicon carbide substrate (30, 30V);
a gate insulating film (41) provided on said silicon carbide substrate; and
a gate electrode (50) provided on said gate insulating film, said gate electrode including a polysilicon film (51) in contact with said gate insulating film, a barrier film (52) provided on said polysilicon film, and a metal film (53) provided on said barrier film and made of refractory metal;
an interlayer insulating film (42) arranged so as to cover said gate insulating film and said gate electrode provided on said gate insulating film, and having a substrate contact hole (SH) partially exposing said silicon carbide substrate in a region in contact with said gate insulating film; and
an interconnection (71) electrically connected to said silicon carbide substrate through said substrate contact hole, and electrically insulated from said gate electrode by said interlayer insulating film.

2. The silicon carbide semiconductor device according to claim 1, wherein said interlayer insulating film has a gate contact hole (GH) partially exposing said gate electrode, and
the silicon carbide semiconductor device further comprises:
a gate pad (72) electrically connected to said gate electrode through said gate contact hole.

3. The silicon carbide semiconductor device according to claim 2, wherein said interconnection and said gate pad are made of the same material.

4. The silicon carbide semiconductor device according to any one of claims 1 to 3, wherein said refractory metal has a melting point exceeding 1000°C.

5. The silicon carbide semiconductor device (102, 103) according to any one of claims 1 to 4, wherein said silicon carbide substrate (30V) is provided with a trench (TU, TV), and at least a part of said gate electrode is arranged in said trench.

6. A method for manufacturing a silicon carbide semiconductor device (101-103), comprising the steps of:
forming a gate insulating film (41) on a silicon carbide substrate (30, 30V);
forming a gate electrode (50) on said gate insulating film, said step of forming a gate electrode including the steps of forming a polysilicon film (51) in contact with said gate insulating film, forming a barrier film (52) on said polysilicon film, and forming a metal film (53) made of refractory metal on said barrier film;
forming an interlayer insulating film (42) arranged so as to cover said gate insulating film and said gate electrode provided on said gate insulating film, and having a substrate contact hole (SH) partially exposing said silicon carbide substrate in a region in contact with said gate insulating film; and
forming a interconnection (71) which is electrically connected to said silicon carbide substrate through said substrate contact hole, and electrically insulated from said gate electrode by said interlayer insulating film.

7. The method for manufacturing a silicon carbide semiconductor device according to claim 6, further comprising the step of applying heat treatment to said silicon carbide substrate to make electrical connection between said interconnection and said silicon carbide substrate be more ohmic.

8. The method for manufacturing a silicon carbide semiconductor device according to claim 7, wherein said step of applying heat treatment to said silicon carbide substrate includes the step of heating said silicon carbide substrate to a temperature over 1000°C.

9. The method for manufacturing a silicon carbide semiconductor device according to any one of claims 6-8, wherein said step of forming interconnection includes the steps of forming a conductor film (70) in contact with each of said gate electrode and said silicon carbide substrate, and patterning said conductor film, said step of patterning forming said interconnection and a gate pad (72) provided on a part of said gate electrode.

10. The method for manufacturing a silicon carbide semiconductor device (102, 103) according to any one of claims 6-9, further comprising the step of forming a trench (TU, TV) in said silicon carbide substrate (30V), wherein at least a part of said gate electrode is arranged in said trench.

## Amended claims

### Amended claims under Art. 19.1 PCT

**1.** (Amended) A silicon carbide semiconductor device (102, 103), comprising:
a silicon carbide substrate (30V);
a gate insulating film (41) provided on said silicon carbide substrate; and
a gate electrode (50) provided on said gate insulating film, said gate electrode including a polysilicon film (51) in contact with said gate insulating film, a barrier film (52) provided on said polysilicon film, and a metal film (53) provided on said barrier film and made of refractory metal;
an interlayer insulating film (42) arranged so as to cover said gate insulating film and said gate electrode provided on said gate insulating film, and having a substrate contact hole (SH) partially exposing said silicon carbide substrate in a region in contact with said gate insulating film; and
an interconnection (71) electrically connected to said silicon carbide substrate through said substrate contact hole, and electrically insulated from said gate electrode by said interlayer insulating film, wherein
said silicon carbide substrate (30V) is provided with a trench (TU, TV), and at least a part of said gate electrode being arranged in said trench, and said trench having a V-shape or a shape with a combination of said V-shape and a flat bottom portion.

**2.** The silicon carbide semiconductor device according to claim 1, wherein said interlayer insulating film has a gate contact hole (GH) partially exposing said gate electrode, and
the silicon carbide semiconductor device further comprises:
a gate pad (72) electrically connected to said gate electrode through said gate contact hole.

**3.** The silicon carbide semiconductor device according to claim 2, wherein said interconnection and said gate pad are made of the same material.

**4.** The silicon carbide semiconductor device according to any one of claims 1 to 3, wherein said refractory metal has a melting point exceeding 1000°C.

**5.** (Canceled)

**6.** (Amended) A method for manufacturing a silicon carbide semiconductor device (102, 103), comprising the steps of:
forming a trench (TU, TV) in a silicon carbide substrate (30V), said trench having a V-shape or a shade with a combination of said V-shape and a flat bottom portion;
forming a gate insulating film (41) on said silicon carbide substrate;
forming a gate electrode (50) on said gate insulating film, at least a part of said gate electrode being arranged in said trench, and
said step of forming a gate electrode including the steps of forming a polysilicon film (51) in contact with said gate insulating film, forming a barrier film (52) on said polysilicon film, and forming a metal film (53) made of refractory metal on said barrier film;
forming an interlayer insulating film (42) arranged so as to cover said gate insulating film and said gate electrode provided on said gate insulating film, and having a substrate contact hole (SH) partially exposing said silicon carbide substrate in a region in contact with said gate insulating film; and
forming an interconnection (71) which is electrically connected to said silicon carbide substrate through said substrate contact hole, and electrically insulated from said gate electrode by said interlayer insulating film.

**7.** The method for manufacturing a silicon carbide semiconductor device according to claim 6, further comprising the step of applying heat treatment to said silicon carbide substrate to make electrical connection between said interconnection and said silicon carbide substrate be more ohmic.

**8.** The method for manufacturing a silicon carbide semiconductor device according to claim 7, wherein said step of applying heat treatment to said silicon carbide substrate includes the step of heating said silicon carbide substrate to a temperature over 1000°C.

**9.** The method for manufacturing a silicon carbide semiconductor device according to any one of claims 6-8, wherein said step of forming interconnection includes the steps of forming a conductor film (70) in contact with each of said gate electrode and said silicon carbide substrate, and patterning said conductor film, said step of patterning forming said interconnection and a gate pad (72) provided on a part of said gate electrode.

**10.** (Canceled)
